# EUROPEAN PATENT APPLICATION

(11) **EP 1 764 802 A1**
(43) Date of publication of application: **21.03.2007**
(21) Application number: 05020382.7
(22) Date of filing: 19.09.2005
(51) Int. Cl.: G11C 5/04, H05K 7/10

(54) **Memory embedding seat with pin matrix**

(71) Applicant: Lih Duo International Co., Ltd., Wu Gu Shiang, Taipei Hsien (TW)
(72) Inventor: Wang, Sung-Lai, Taipei Hsien (TW)
(74) Representative: Helms, Joachim

(57) **Abstract**

A printed circuit board (20) provided with one or more than one memory-embedding seat (30) fixed on one or two sides of the printed circuit board (20), each memory-embedding seat (30) has a holding compartment (31) for embedding or removing a memory chip (40); the holding compartment (31) has a conductive pin array (33) on a bottom thereof which conductive pin array (33) comprises a plurality of conductive pin units (32) configured in the form of matrix providing flexibleness and conductive functions; particularly, when memory chips (40) are respectively embedded in the memory-embedding seats (30) on the printed circuit board (20) to form a memory module (15) without the need of SMT, solder pastes or fluxes and in conformity with the requirements of environmental protection; when maintenance or replacement is required, what needs to be done is only remove the damaged memory chips (40) and insert a new memory chips (40); and when upgrading is required, users can easily change the memory chip (40) with a new memory chips (40) of larger capacity by themselves.

## Description

### FIELD OF THE PRESENT INVENTION

The present invention relates generally to a printed circuit board (PCB) with an embedding seat for memories, particularly to a memory module whose integrated circuits (ICs) without need of SMT, solder pastes or fluxes can be changed by users.

### DESCRIPTION OF PRIOR ART

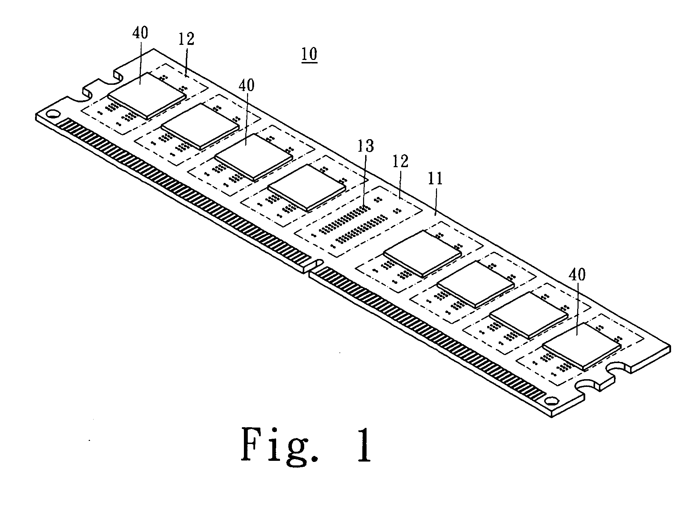

As shown in Fig. 1, a prior art memory module 10 has a plurality of integrated circuits 40, or called memory chips 40, soldered firmly on one or both sides of an integrated circuit board 11.

Taking the memory module 10 with memory chips 40 soldered on one side of the integrated circuit board 11 as an example, the integrated circuit board 11 has a plurality of printed circuit sets 12 and each printed circuit set 12 has a plurality of contacts 13. A memory chip 40 is soldered firmly on the contacts 13 of the printed circuit board 11 and forms an electrical connection with the corresponding printed circuit set 12. The memory module 10 is constructed by integrating a plurality of memory chips 40 on the printed circuit board 11.

The memory chips 40 are the major component of the memory module 10. The packaging method of the memory chips 40 has been progressing from current TSOP (Thin Small Outline Package) to BGA (Ball Grid Array).

When BGA is used for packaging the memory chips 40 of the memory module 10 as shown in Fig. 1, the pads on the bottom of each memory chip 40 are soldered firmly on the contacts 13 of each printed circuit set 12 of the printed circuit board 11 by SMT (Surface Mount Technology), so that each memory chip 40 can be mounted onto the printed circuit board 11 firmly.

However, maintenance and replacement of the memory chip 40 are difficult when pads are used to solder the memory chip 40 onto the printed circuit board 11. For both maintenance and replacement, high temperature is required for de-soldering to remove the pads between the memory chip 40 to be replaced and the printed circuit board 11. The new memory chip 40 must undergo re-embedding and re-positioning of pads for replacement, and these processes are difficult to implement. Especially, good chips 40 are often damaged by the heat during the removal of the pads under high temperature. Further, solder pastes and fluxes used for re-embedding of the pads are unfriendly to the environment and not in conformity to the requirements of environmental protection.

### SUMMARY OF THE PRESENT INVENTION

To overcome the difficulty in maintenance and replacement of chips on conventional memory modules, the primary objective of the present invention is to provide a printed circuit board with a memory-embedding seat on one side thereof and the memory-embedding seat is used for BGA-packaged memory chips for easy embedding and removal. When embedded in the memory-embedding seat on the printed circuit board, the memory chips form an electrical connection with the printed circuit board without the need of SMT, solder pastes, or fluxes. In this way, the memory chips together with the printed circuit board form a memory module.

When maintenance or replacement is required, what needs to be done is only removing the damaged chip out of the memory-embedding seat and inserting a new chip. The process of re-embedding and re-positioning of pads is thoroughly removed.

Further more, the present invention provides the following advantages:
1. Easy maintenance and replacement of the memory chips;
2. Reducing the cost and simplifying the process by removing the process of pads;
3. Maintaining and replacing the memory chips without the need of re-positioning;
4. Protection of memory chips from being damaged by heat;
5. Easy for users to change or upgrade the printed circuit board with memory chips of larger capacity;
6. The memory-embedding seat ensuring reuse of the printed circuit board; which is capably reduced amount of solder pastes and fluxes for environmental protection; and
7. Improvement of the yield rate.

The printed circuit board of the present invention comprises a base plate and at least one memory-embedding seat. A plurality of printed circuit sets with the same function is disposed on one side of the base plate and each memory-embedding seat corresponds to a printed circuit set on the base plate and is fixed on one side thereof. Each memory-embedding seat has a holding compartment for embedding a memory chip. The holding compartment has a conductive pin array on a bottom thereof. The conductive pin array comprises a plurality of conductive pin units configured in the form of a matrix providing flexibleness and conductive functions. Hence, an electrical connection is formed between each memory-embedding seat and one of the printed circuit sets on the base plate via the conductive pin units. When a BGA-packaged memory chip is embedded in the memory-embedding seat on the printed circuit board, an electrical connection is formed between the memory chip and the conductive pin array of the memory-embedding seat via the pads on the bottom of the memory chip, and further an electrical connection is formed between the memory chip and one of the printed circuit sets on the base plate via the conductive pin units. A completed memory module is constructed in this way. When maintenance or replacement is required, what needs to be done is only removing the damaged chip and inserting a new chip. When upgrading is required, users can easily change the memory chip with a new chip of larger capacity by themselves.

### BRIEF DESCRIPTION OF THE DRAWING

Fig. 1 shows a structural diagram of a memory module of the prior art;
Fig. 2 shows a structural diagram of a printed circuit board of the present invention with a memory-embedding seat of on one side thereof;
Fig. 3 shows a magnified diagram of the memory-embedding seat as shown in Fig. 2;
Fig. 4 shows a magnified cross-sectional diagram of the memory-embedding seat along the 4--4 line as shown in Fig. 2;
Fig. 5 shows a structural diagram of the memory module of the present invention; and
Fig. 6 shows a combined magnified cross-sectional diagram of the memory-embedding seat and the memory chip along the 6--6 line as shown in Fig. 5.

### DESCRIPTION OF THE PREFERRED EMBODIMENTS

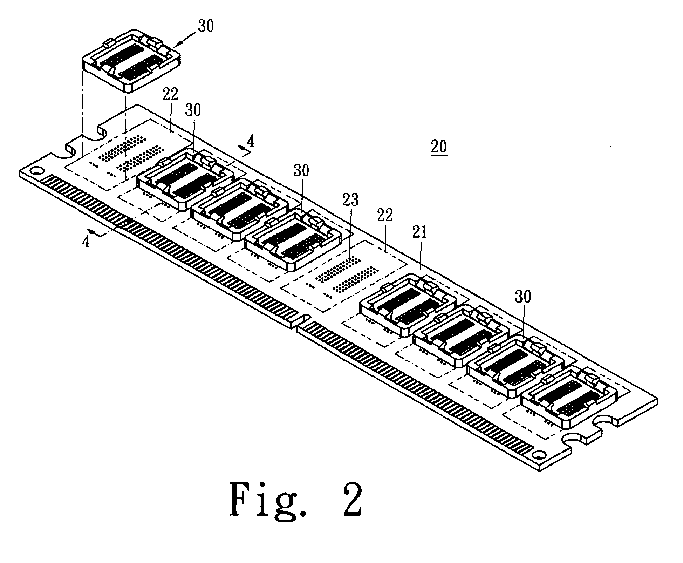

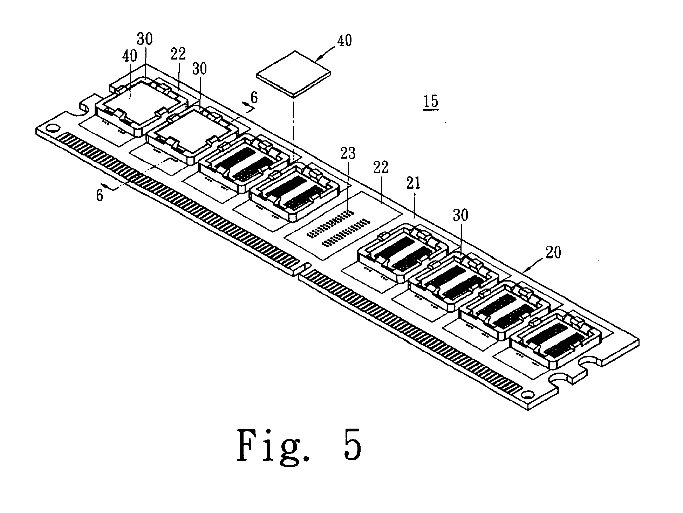

As shown in Figs. 2 and 5, the printed circuit board 20 of the present invention is applicable to memory modules and easy for assembly and removal of memory chips 40.

The printed circuit board 20 has a base plate 21 and at least one memory-embedding seat 30. A plurality of printed circuit sets 22 with the same functions is disposed on one or two sides of the base plate 21 and each printed circuit set 22 has a plurality of contacts 23.

Each memory-embedding seat 30 corresponds to a printed circuit set 22 on the base plate 21 and is fixed on one or two sides thereof to form an electrical connection with the printed circuit set 22.

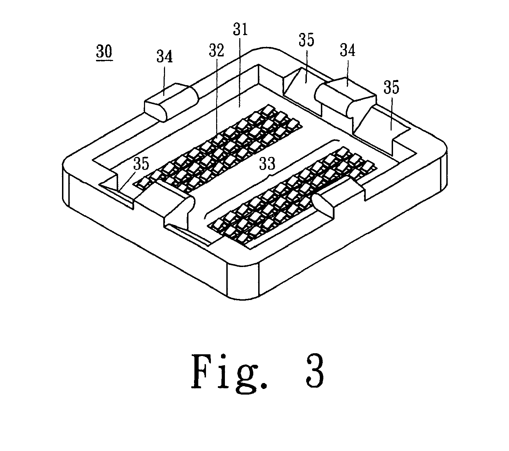

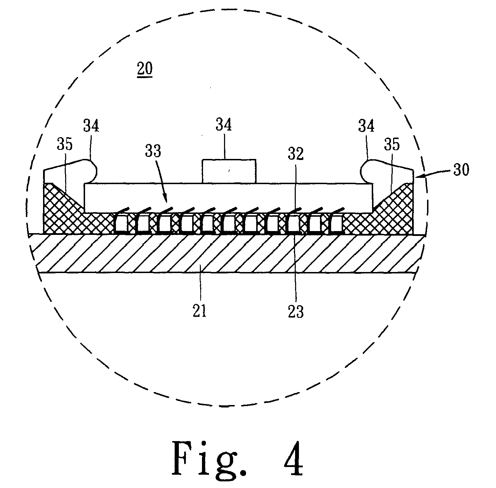

As shown in Fig. 3, each memory-embedding seat 30 has a holding compartment 31 for embedding a BGA-packaged memory chip 40 as shown in Fig. 5, or removing the same out of the holding compartment 31. A conductive pin array 33 is disposed on a bottom of the holding compartment 31. The conductive pin array 33 comprises a plurality of conductive pin units 32 configured in the form of a matrix providing flexibleness and conductive functions. Each conductive pin unit 32 is a metal spring, a flexible probe pin, or a metal dome as shown in Fig. 3 and 4.

As shown in Figs. 2 and 4, an electrical connection is formed between each memory-embedding seat 30 and its correspondingly related printed circuit sets 22 on the base plate 21 via the conductive pin units 32 of the conductive pin array 33. Or, an electrical connection is formed between each memory-embedding seat 30 and the printed circuit board 22 via the contact 23 of a printed circuit set 22 on the base plate 21.

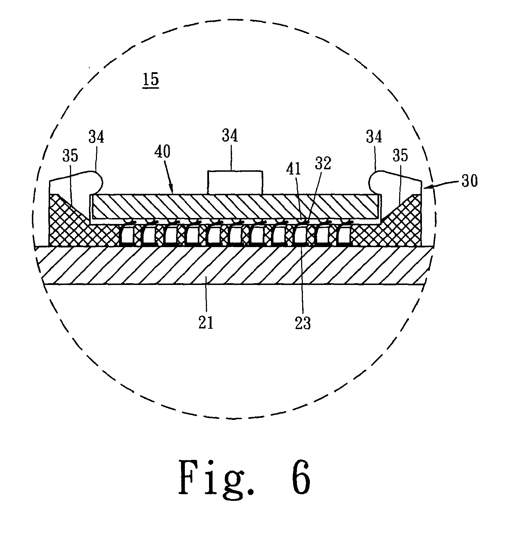

As shown in Figs. 5 and 6, the memory module 15 of the present invention comprises the aforementioned printed circuit board 20 and at least one memory chip 40. The memory chip 40 is BGA-packaged with pads 41 or contacts on the bottom thereof and can be embedded in the holding compartment 31 of the memory-embedding seat 30 on the printed circuit board 20. The memory chip 40 that has been embedded in the holding compartment 31 can be removed easily.

When the memory chip 40 is embedded in the memory-embedding seat 30 on the printed circuit board 20, an electrical connection is formed between the memory chip 40 and the conductive pin units 32 of the memory-embedding seat 30 via the pads 41 or contacts on the bottom of the memory chip 40, and thus an electrical connection is further formed between the memory chip 40 and one of the printed circuit sets 22 on the printed circuit board 20.

Hence, no SMT, solder plates or flux is required for assembly of the memory module 15 with the printed circuit board 20 and the memory chip 40 of the present invention and, thus, the assembly is environmentally friendly.

When maintenance or replacement of any damaged memory chip 40 on the memory module 15 is required, what needs to be done is only removing the damaged memory chip 40 out of the printed circuit board 20 and inserting a new memory chip 40.

Since no de-soldering under high temperature is required for the maintenance and replacement of the memory chip 40, the risk that the memory chip 40 is damaged by heat and the requirement for re-embedding and re-positioning of pads are removed.

When memory chips 40 of larger capacity are required for upgrading of the memory module 15, users only need to remove the current memory chips 40 out of the printed circuit board 20 and insert new memory chips 40 of larger capacity. The upgrading of the memory chips 40 can be easily done by users and the printed circuit board 20 of the present invention can be reused after the upgrading.

As shown in Fig. 3, plurality of protruding locks 34 and indented notches 35 is disposed internally on the periphery of the holding compartment 31 of the memory-embedding seat 30. The locks 34 have flexibility in structure. When embedded in the holding compartment 31 of the memory-embedding seat 30 on the printed circuit board 20, the memory chip 40 is locked by the locks 34 of the memory-embedding seat 30 so that the memory chip 40 will not come out of the holding compartment 31.

When maintenance of the memory module 15 or change of the memory chip 40 is required, users only need to push the memory chip 40 from the notches 35 of the memory-embedding seat 30 to unlock and remove the memory chip 40.

Another embodiment of the present invention is to pivotably mount a movable upper cover (not shown in the figures) on the memory-embedding seat 30 to lift upwards or close downwards against the memory-embedding seat 30. When the upper cover is lifted upwards, the memory chip 40 can be inserted in the holding compartment 31 of the memory-embedding seat 30, or moved out of the holding compartment 31 of the memory-embedding seat 30. When the upper cover is closed downwards onto the memory-embedding seat 30, the memory chip 40 is fixed by the cover on the holding compartment 31 of the memory-embedding seat 30.

The memory module 15 of the present invention is applicable to personal computers and notebooks, so that users may easily maintain and replace any damaged memory chip 40 by inserting a new chip on the memory module 15, and, when upgrading is required, users can easily change the memory chip 40 with a new chip of larger capacity by themselves.

A further embodiment of the printed circuit board 20 of the present invention is to apply the structure of the memory-embedding seat 30 onto the printed circuit board of a VGA (Video Graphic Array) display card, so that the memory chip of the printed circuit board can be easily assembled and removed. As a result, the base plate 21 of the printed circuit board 20 of the present invention is applicable to both memory modules and VGA display cards.

## Claims

1. A printed circuit board comprising a base plate (21) with a plurality of printed circuit sets (22), **characterized in that** one or more than one memory-embedding seat (30) fixed on one or two sides of the base plate (21), each memory-embedding seat (30) having a holding compartment (31) with a conductive pin array (33) on a bottom thereof, the conductive pin array (33) comprising a plurality of conductive pin units (32) configured in a form of matrix providing flexibleness and conductive functions; and the conductive pin units (32) electrically connecting to one of the printed circuit sets (22).

2. The printed circuit board as cited in Claim 1, **characterized in that** the conductive pin unit (32) of the memory-embedding seat (30) is a metal spring, a metal dome, or a probe pin.

3. The printed circuit board as cited in Claim 1 or 2, **characterized in that** the base plate (21) is a printed circuit board of a memory module.

4. The printed circuit board as cited in Claim 1 or 2, **characterized in that** the base plate (21) is a printed circuit board of a VGA display card.

5. The printed circuit board as cited in Claim 1 or 2, **characterized in that** a plurality of protruding locks (34) is disposed on a periphery of the holding compartment (31) of the memory-embedding seat (30).

6. The printed circuit board as cited in Claim 1 or 2, **characterized in that** a plurality of indented notches (35) is disposed on a periphery of the holding compartment (31) of the memory-embedding seat (30).

7. The printed circuit board as cited in Claim 1 or 2, wherein a movable upper cover is pivotably mounted on the memory-embedding seat (30).

8. A memory module comprising a base plate (21) with a plurality of printed circuit sets (22), **characterized in that** one or more than one memory-embedding seat (30) fixed on one or two sides of the base plate (21), each memory-embedding seat (30) having a holding compartment (31) with a conductive pin array (33) on a bottom thereof, the conductive pin array (33) comprising a plurality of conductive pin units (32) configured in a form of matrix providing flexibleness and conductive functions; and the conductive pin units (32) electrically connecting to one of the printed circuit sets (22); and one or more than one memory chip (40) respectively embedded in the holding compartment (31) of the corresponding memory-embedding seat (30) on the base plate (21), and a plurality of pads or contacts being disposed on a bottom of each memory chip (40) are electrically connected to the conductive pin array (33) of the corresponding memory-embedding seat (30).

9. The memory module as cited in Claim 8, **characterized in that** the conductive pin unit (32) of the memory-embedding seat (30) is a metal spring, a metal dome or a probe pin.
